# EUROPEAN PATENT SPECIFICATION

(11) **EP 0 675 365 B1**
(45) Date of publication and mention of the grant of the patent: **07.11.2001**
(21) Application number: 95104563.2
(22) Date of filing: 28.03.1995
(51) Int. Cl.: G01P 15/09

(54) **Acceleration sensor and method for producing the same**
Beschleunigungsmessaufnehmer und Verfahren zu seiner Herstellung
Capteur d'accélération et procédé pour sa fabrication

(30) Priority: 31.03.1994 JP 6267994
(43) Date of publication of application: 04.10.1995
(73) Proprietor: MATSUSHITA ELECTRIC INDUSTRIAL CO., LTD., Kadoma-shi, Osaka 571-8501 (JP)
(72) Inventor: Otsuchi, Tetsuro, Osaka-shi, Osaka (JP); Kawasaki, Osamu, Tsuzuki-gun, Kyoto (JP); Shintaku, Hidenobu, Neyagawa-shi, Osaka (JP); Suzuki, Shigeo, Hirakata-shi, Osaka (JP); Nishikura, Takahiro, Ikoma-shi, Nara-ken (JP); Imada, Katsumi, Katano-shi, Osaka (JP); Takeda, Katsu, Osaka-shi, Osaka (JP); Sumihara, Masanori, Higashiosaka-shi, Osaka (JP); Nojima, Takashi, Katano-shi, Osaka (JP)
(74) Representative: Kügele, Bernhard

(56) References cited:
- EP-A- 0 626 212
- US-A- 4 017 752
- US-A- 4 494 409
- US-A- 5 009 106
- MESSEN UND PRUFEN, no. 3, 1 March 1990, page 95, 96, 98, 99 XP000175640 BERNHARD BILL: "PIEZOBEAM - EIN NEUARTIGES KONZEPT FUER BESCHLEUNIGUNGSSENSOREN"

## Description

### BACKGROUND OF THE INVENTION

### 1. Field of the Invention:

The present invention relates to an acceleration sensor used for measuring acceleration or detecting vibration; and a method for producing the same. More particularly, the present invention relates to a high-performance acceleration sensor of a small size and a method for producing the same.

### 2. Description of the Related Art:

In recent years, the size of electronic apparatuses have been much reduced, so that a portable electronic apparatus such as a notebook-type personal computer is now widespread. Therefore, there is strong demand for the development of a high-performance acceleration sensor of a small size which may ensure and improve the reliability of electronic apparatuses of this type against impact given to such apparatuses. For example, an impact given to an apparatus which is going to write some data into a high-density hard disk would cause the positional deviation of the writing head thereof. Such positional deviation might result in a write error of the data or might damage the head. In order to prevent such accidents, it is necessary to detect the impact given to the hard disk thereby suspending the writing operation or allowing the head to escape to a safe position.

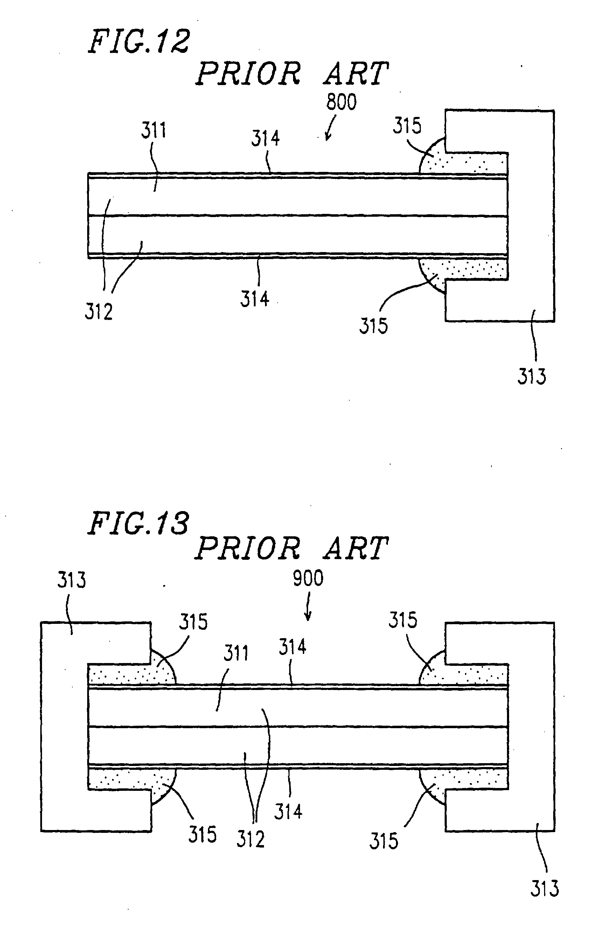

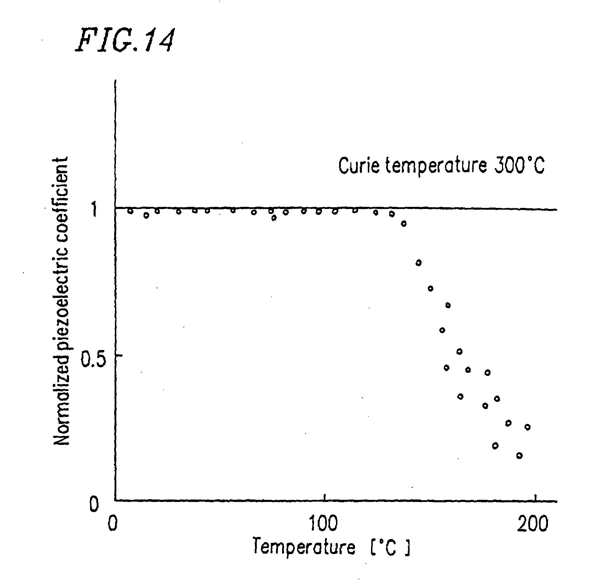

Conventionally, an acceleration sensor has generally been made of a piezoelectric material such as piezoelectric ceramic. An acceleration sensor of this type may accomplish a high detection sensitivity by utilizing the electromechanical transduction characteristics of a piezoelectric material used for the sensor. A piezoelectric acceleration sensor transduces the force given by the acceleration or the vibration into a voltage based on the piezoelectric effects so as to output the voltage. An acceleration sensor of this type is known by a rectangular bimorph piezoelectric element under a cantilever type structure disclosed in Japanese Laid-Open Patent Publication No. 2-248086. Such a cantilever type structure is shown in Figure 12. As shown in Figure 12, one end of the piezoelectric vibrator 311 with a bimorph structure is clamped by a holding member 313 with a conductive adhesive 315 or the like. Since the resonance frequency of such a bimorph piezoelectric element under the cantilever type structure is low, the element is used for measuring acceleration having relatively low frequency components. On the other hand, in the case of measuring the acceleration in a high frequency region, a rectangular bimorph piezoelectric element with a both ends clamped structure shown in Figure 13 is used. As shown in Figure 13, both ends of the piezoelectric vibrator 311 under a bimorph structure are clamped by the holding members 313 with an adhesive 315 or the like. The resonance frequency of the piezoelectric vibrator may be made relatively high by clamping both ends of the piezoelectric vibrator.

Although the acceleration sensor under the cantilever type structure mentioned above exhibits high sensitivity to the vibration in a low frequency region, the acceleration sensor exhibits low sensitivity to the vibration in a high frequency region and low impact-resistance. On the other hand, according to the acceleration sensor under the both ends clamped structure, a wide range of frequency region may be detected and the impact-resistance thereof is high, whereas, the sensitivity to the frequency is disadvantageously low and the downsizing thereof is very difficult.

In addition, in order to stabilize the sensitivity of a rectangular bimorph piezoelectric element, it is necessary to stabilize the resonance frequency thereof. Accordingly, the bimorph piezoelectric element is required to be held under an even stabler state. However, in actual use, some stress generated by mechanical or thermal variations causes a deviation in a portion supported by a metallic supporting member or in a portion clamped by a metallic holding member. For example, in the case of clamping the bimorph piezoelectric element by using an adhesive, the clamp point of the element changes depending on the application range of an adhesive. In addition, in accordance with the variation of the temperature of the adhesive, the clamping state of the element is varied, so that it becomes difficult to hold the element under a satisfactorily stable state.

An exemplary method for stably clamping a piezoelectric element is disclosed in Japanese Laid-Open Patent Publication No. 59-70923. In this patent publication, a slit is provided in a central portion of a bimorph piezoelectric vibrator, thereby forming a cantilever type structure so as to clamp the peripheral portion of the bimorph piezoelectric vibrator. According to this method, however, the area of the holding portion, other than the cantilever type structure formed by the slit for contributing to the detection of the acceleration, is large, so that the size of the element also becomes disadvantageously large as a whole. Therefore, it is difficult to produce a small-sized acceleration sensor by this method.

In order to improve the sensitivity to acceleration, it is preferable to support the piezoelectric vibrator so that the inclination of the displacement of the vibrator, which is caused by the vibration, is limited at the supported point, as compared with completely clamping the piezoelectric vibrator so that the inclination of the displacement becomes zero at the clamp point. This is because the same acceleration gives a larger distortion to the piezoelectric vibrator supported by the former method, as compared with the distortion given to the piezoelectric vibrator completely clamped by the latter method. As a result, the output sensitivity of the piezoelectric vibrator held by the former method becomes larger. According to the conventional method mentioned above, however, it is difficult to stabilize the supporting state; the supporting state and the clamping state are interchangeable depending upon the fabrication conditions; the variation of the resonance frequency of the piezoelectric vibrator becomes large; and therefore the variation of the sensitivity to the acceleration also becomes adversely large.

Japanese Laid-Open Utility Model Publication No. 5-23617 discloses a holding structure for constituting a piezoelectric resonator in which a piezoelectric vibrator is held at square pillar shaped metallic protrusions formed on the surface of the piezoelectric vibrator. Unlike an acceleration sensor, the piezoelectric resonator disclosed in Japanese Laid-Open Utility Model Publication No. 5-23617 is an element utilizing the resonance phenomena of a vibrator, and therefore the metallic protrusions are provided at the position of the node of the vibrator so as not to obstruct the resonance of the vibrator. According to this utility model publication, the square pillar shaped metallic protrusions are formed by brazing, welding, melting, adhesion, or the like.

In the case of forming the metallic protrusions by brazing, welding or melting, the piezoelectric vibrator is heated at a high temperature during the formation of the protrusions, so that the characteristics of the piezoelectric vibrator deteriorate. In particular, in the case where piezoelectric ceramic is used as a material for the vibrator, the characteristics of the vibrator deteriorate greatly when it is heated to a high temperature, because the Curie temperature of a piezoelectric ceramic material is low and so the heat resistance thereof is low. The Curie temperature of a piezoelectric ceramic material used for a piezoelectric vibrator is approximately in the range of 250 to 350°C. If a piezoelectric vibrator is heated at a temperature half as high as the Curie temperature (centigrade) or higher, i.e. in the range of 125 to 175°C or higher, then the characteristics of the piezoelectric vibrator deteriorate considerably. Therefore, in the case where the protrusions are formed on the piezoelectric vibrator by such a process as brazing and soldering in which the vibrator is heated at a high temperature, considerable deterioration of the piezoelectric vibrator is inevitable. Figure 14 is a graph showing the relationship between the piezoelectric constant of a piezoelectric ceramic material and the heating temperature. In this case, the piezoelectric ceramic material with a Curie temperature of 300°C is heated for an hour. As shown in Figure 14, the piezoelectric constant does not change until the heating temperature reaches 140°C, but the piezoelectric constant decreases when the heating temperature is over 140°C. As the heating temperature becomes higher, the piezoelectric constant decreases in shorter time (not shown in Figure 14). In fact, if the protrusions are formed on the piezoelectric vibrator by a process such as brazing and soldering, then the characteristics of the piezoelectric vibrator are considerably degraded.

On the other hand, in the case where the metallic protrusions are formed on the piezoelectric vibrator by using an adhesive, the adhesive protrudes from the adhesion interface between the piezoelectric vibrator and the protrusions. Since the amount of the protruding adhesive is not constant, the variation and the deterioration of the characteristics of the vibrator are disadvantageously large.

In principle, it is possible to form the metallic protrusions by a plating process without heating the vibrator at a high temperature. However, it takes a long time to form a thick protrusion by a plating process, so that a protrusion with a thickness of only several µm can be formed practically. If a piezoelectric vibrator made of a piezoelectric ceramic material is held at protrusions with such a small height, even only a slight inclination of the piezoelectric vibrator will make the vibrator come in contact with the holding member or the like for holding the protrusions, because the surface of a piezoelectric ceramic material has a ruggedness of 3 to 5 µm. The contact of the piezoelectric vibrator with another member is equivalent to the displacement of the portion holding the piezoelectric vibrator, so that the length from the hold point of the piezoelectric vibrator to the extremity thereof changes, thereby varying the resonance frequency and the frequency characteristics of the piezoelectric vibrator. In the case of forming the protrusions by a printing process or the like using an organic material auch as a conductive paste, it is also difficult to form thick protrusions, so that the same kinds of problems occur as those of the plating process. In addition, the protrusions obtained by a printing process have weak mechanical strength and weak adhesive strength. Accordingly, it is difficult to hold the piezoelectric vibrator stably.

The document US-A-4 017 751 describes a piezoelectric ceramic resonator mounting means. Protrusions may be provided of electrically conductive material in node regions of a piezoelectric vibrator, which are contacted by an elastic holding body.

Also, the document US-A-4 494 409 describes an engine vibration sensor, the vibrator being composed of a piezoelectric plate and having a root and a vibrator element. A base is provided to be connected to the engine body, and a clamp for retaining the root firmly between the clamp and the base. The clamp may be provided with a projection having a flat surface for retaining the root of the vibrator.

### SUMMARY OF THE INVENTION

The acceleration sensor of the invention includes: a piezoelectric vibrator including a piezoelectric element having a first principal surface and a second principal surface opposed each other, a first and a second electrode formed on the first and the second principal surface, and conductive protrusions made or a metal material or a ceramic material and formed by a thermal spraying process; and a holding body for holding the piezoelectric vibrator via the conductive protrusions.

In one embodiment of the invention, the conductive protrusions are formed in longitudinal central portions of the piezoelectric vibrator.

In another embodiment of the invention, the holding body includes a holding member having an elastic property, and the piezoelectric vibrator is held by the holding member via at least one of the conductive protrusions formed on the first and second electrode piezoelectric vibrator.

In still another embodiment of the invention, the piezoelectric vibrator is press-fitted into the holding body and the piezoelectric vibrator is held via the conductive protrusions by the holding body.

In still another embodiment of the invention, the holding body includes a holding member made of a material having a lower hardness than that of the conductive protrusions and at least one of the protrusions is press-fitted into the holding member.

In still another embodiment of the invention, the piezoelectric element is selected from a group including: a bimorph piezoelectric element; a multi-layered piezoelectric element obtained by attaching multiple piezoelectric plates; a single layered piezoelectric element; a unimorph piezoelectric element obtained by attaching a piezoelectric plate to a shim; a bimorph piezoelectric element interposing a shim therebetween; and a piezoelectric element including a piezoelectric film deposited on a substrate and an electrode.

In still another embodiment of the invention, the piezoelectric vibrator further includes protrusions made of a metal material or a ceramic material and formed by - a thermal spraying process in longitudinal end portions of the piezoelectric vibrator on at least one of the first and second electrodes.

In still another embodiment of the invention, the conductive protrusions are arranged in a symmetric manner on the first and second electrodes.

In still another embodiment of the invention, the conductive protrusions are linear protrusions extending in a width direction of the piezoelectric vibrator.

In still another embodiment of the invention, a length in a longitudinal direction of the piezoelectric element is longer than 3.5 times of that in a width direction.

In still another embodiment of the invention, a height of the conductive protrusions is in a range of 50 µm to 150 µm.

According to another aspect of the invention, a method for producing an acceleration sensor including a piezoelectric vibrator including a piezoelectric element having a first principal surface and a second principal surface opposed each other, a first and a second electrode formed on the first and the second principal surface is provided. The method includes the step of: forming a conductive protrusion by thermally spraying a metal material or a ceramic material on at least one of the first and second electrodes.

In one embodiment of the invention, the method further includes a step of forming a holding body for holding the piezoelectric element via the conductive protrusion.

In another embodiment of the invention, the conductive protrusion forming step includes a step of forming the protrusion on the piezoelectric element by thermally spraying a metal material or a ceramic material via a mask having an opening in a portion corresponding to a longitudinal central portion of the piezoelectric vibrator.

In still another embodiment of the invention, the opening is a linear opening extending in a width direction of the piezoelectric vibrator.

In still another embodiment of the invention, the protrusion is formed on the first and the second electrodes.

In still another embodiment of the invention, a height of the conductive protrusions is in a range of 50 µm to 150 µm.

In still another embodiment of the invention, the holding body include a holding member having an elastic property, and the piezoelectric vibrator is held by the holding member via at least one of the conductive protrusions formed on the first and second electrode piezoelectric vibrator.

In still another embodiment of the invention, the holding body includes a holding member made of a material having a lower hardness than that of the conductive protrusions and at least one of the protrusions is press-fitted into the holding member.

In still another embodiment of the invention, the method further includes a step of forming protrusions by thermally spraying a metal material or a ceramic material in longitudinal end portions of the piezoelectric vibrator on at least one of the first and second electrodes.

The piezoelectric vibrator of the acceleration sensor of the invention includes electrically conductive protrusions, made of a metal material or a ceramic material, formed by a thermal spraying process and is held through at least one of the conductive protrusions. The conductive protrusion formed by the thermal spraying process has a high mechanical strength, thererby holding the piezoelectric vibrator stably. Therefore, the accelerator has improved shock resistance. Moreover, by holding the piezoelectric vibrator at its center portion, the end portions thereof may vibrate freely in the same way as a piezoelectric vibrator under a cantilever type structure, so that the piezoelectric vibrator exhibits high sensitivity and is also capable of measuring vibrations (accelerations) with high frequency components. Moreover, since the conductive protrusions are formed by a thermal spraying process, the piezoelectric element is never heated at a high temperature during the processing of the element, thereby preventing the thermal deterioration of the piezoelectric characteristics. The area required for holding the piezoelectric vibrator is small, so that an element may be downsized. Furthermore, since the conductive protrusions may be processed by the thermal spraying process with high precision, it becomes possible to provide a production method excellent in the reproducibility of the piezoelectric characteristics, the stable mass-productivity. In addition, the conductive protrusions are formed on the electrode on the piezoelectric vibrator, so that the charges generated by the acceleration (or the vibration) may be output to an external electrode easily.

Thus, the invention described herein makes possible the advantage of providing (1) a small-sized acceleration sensor having excellent impact-resistance and high sensitivity over a wide frequency range and (2) a method for producing the same.

This and other advantages of the present invention will become apparent to those skilled in the art upon reading and understanding the following detailed description with reference to the accompanying figures.

### BRIEF DESCRIPTION OF THE DRAWINGS

Figure 1 is a perspective view of a piezoelectric vibrator for constituting an acceleration sensor according to an example of the present invention.

Figure 2 is a series of perspective views showing the steps (S1-S5) for producing the piezoelectric vibrator by the method according to one example of the present invention.

Figure 3 is a schematic view showing a thermal spraying process according to an example of the present invention.

Figure 4 is a cross-sectional view of an acceleration sensor according to an example of the present invention.

Figure 5 is a circuit diagram for an acceleration sensor according to an example of the present invention.

Figure 6 is a perspective view of a piezoelectric vibrator for constituting an acceleration sensor according to another example of the present invention.

Figure 7 is a cross-sectional view of an acceleration sensor according to another example of the present invention.

Figure 8 is a perspective view of a piezoelectric vibrator for constituting an acceleration sensor according to still another example of the present invention.

Figure **9** is a cross-sectional view of an acceleration sensor according to still another example of the present invention.

Figure 10 is a cross-sectional view of the acceleration sensor taking along a line X-X in Figure 9.

Figures **11A** and **11B** are plan views of alternative dispositions of the protrusions to be formed on a piezoelectric vibrator according to other examples of the present invention.

Figure 12 is a cross-sectional view showing a structure for a conventional acceleration sensor.

Figure 13 is a cross-sectional view showing a structure for another conventional acceleration sensor.

Figure 14 is a graph showing the relationship between a piezoelectric coefficient and the heating temperature.

### DESCRIPTION OF THE PREFERRED EMBODIMENTS

Hereinafter, the present invention will be described by way of illustrative examples with reference to the accompanying figures.

### Example 1

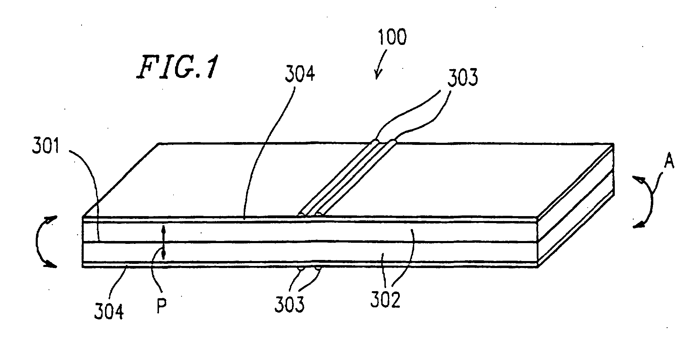

Figure 1 is a perspective view of a piezoelectric vibrator 100 constituting an acceleration sensor according to an example of the present invention. The piezoelectric vibrator 100 shown in Figure 1 includes, as a piezoelectric element, a bimorph piezoelectric element 301 formed by attaching two plates made of a piezoelectric material, e.g. piezoelectric ceramic plates 302, to each other. An electrode 304 is formed on each of the opposed principal surfaces of the piezoelectric ceramic plates 302. Protrusions 303 made of molybdenum, nichrome, or the like are linearly formed on the respective electrodes 304 in the central portions of the opposed surfaces of the bimorph piezoelectric element 301 by a thermal spraying process. In this example, two linear protrusions 303 are provided on each surface of the bimorph piezoelectric element 301 in order to support the bimorph piezoelectric element 301 stably. In this case, the width and the thickness of the respective protrusions 303, and the gap between the two protrusions 303 formed on each surface are determined so that the protrusions 303 support the bimorph piezoelectric element 301 stably in view of the vibration-resistance and the impact-resistance thereof, and the effect to be given to the characteristics of the bimorph piezoelectric element 301. In this example, the width of one linear protrusion is set to be 0.2 mm; the gap between the pair of protrusions is set to be 0.3 mm: and the thickness is set to be 0.1 mm. The protrusions 303 are required to be mechanically stable even under the supporting force, and to exhibit constant electrical properties for functioning as the lead lines. Therefore, the material for the protrusions 303 is selected in consideration of the electrical conductivity, the elastic modulus (or the hardness), and the rust-resistance thereof.

In this example, a piezoelectric ceramic plate with a length of 5 mm, a width of 0.7 mm, and a thickness of 0.1 mm is used as each piezoelectric ceramic plate 302. Accordingly, the thickness of the bimorph piezoelectric element 301 becomes 0.2 mm. In order to generate a flexural vibration (bending vibration) effectively, it is preferable to set the length L of the bimorph piezoelectric element to be 3.5 times as long as the width W thereof or longer, more preferably, 5 times as long as the width or longer. The protrusions 303 are preferably formed in the vicinity of the central portions of the bimorph piezoelectric element 301 in the longitudinal direction, and preferably disposed symmetrically to the center line in the longitudinal direction. The number and the positions of the linear protrusions may be different on the two surfaces of the bimorph piezoelectric element. However, it is preferable that the numbers and the positions of the protrusions are same on both of the two surfaces.

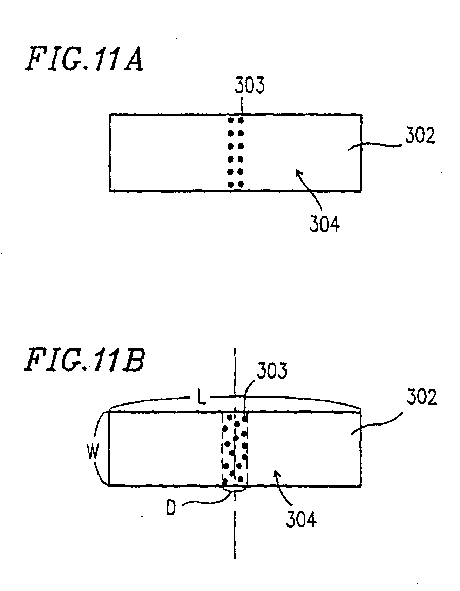

The height (thickness) of the protrusions is suitably in the range of 20 to 150 µm, more preferably in the range of 50 to 100 µm. The shape of each protrusion is not limited to a linear shape, but may be a dot shape. As shown in Figure 11A, a plurality of dot-shaped protrusions may be disposed linearly. Alternatively, as shown in Figure 11B, a plurality of dot-shaped protrusions may be disposed at random within a region of a predetermined width D in the central portion in the longitudinal direction. In Figure 11B, L and W denote the longitudinal length and width of the piezoelectric plate 302, respectively. The width D of this region is preferably in a range of 200 to 800 µm, more preferably in a range of 200 to 500 µm. That is, the ratio D/L is preferably in a range of 0.04 to 0.16, more preferably in a range of 0.04 to 0.1. If the ratio D/L is lower than 0.04, the shock-resistance may not be sufficient. If the ratio D/L is larger than 0.1, the sensitivity may not be sufficient.

In an acceleration sensor, unless the frequency region to be detected is sufficiently apart from the resonance frequency, the detection sensitivity disadvantageously depends on the frequency. In order to obtain an acceleration sensor exhibiting linear characteristics over a wide frequency region, it is necessary to use a piezoelectric vibrator with a high resonance frequency. In this example, the resonance frequency of the piezoelectric vibrator is 20 kHz, so that the acceleration in the frequency range of 50 Hz to 10 kHz may be measured with high accuracy. The acceleration which can be measured is in the range of 0 to 1500 G, so that excellent linear characteristics are obtained with respect to the acceleration of 20 G or more.

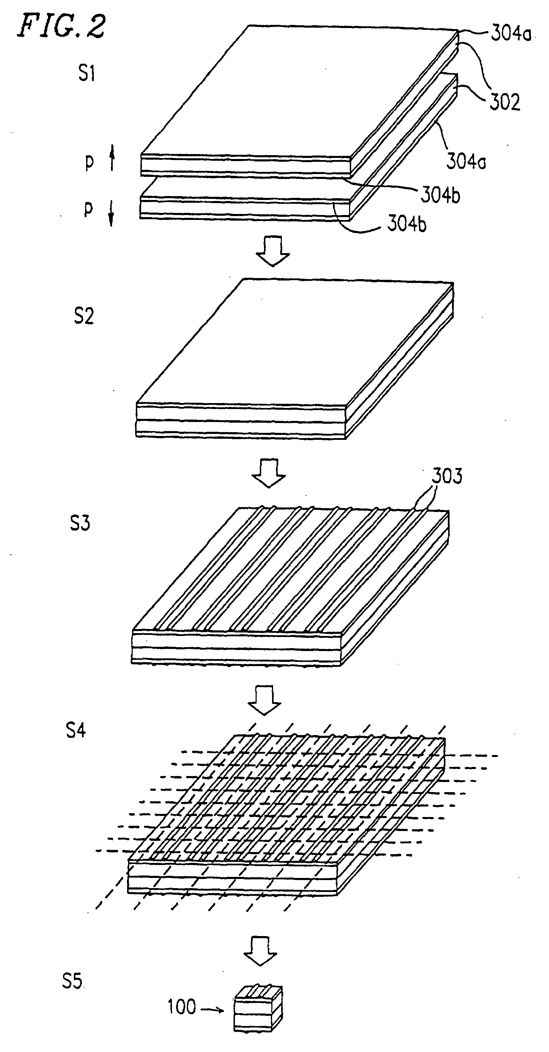

The protrusions 303 are formed by a thermal spraying process. The thermal spraying process makes it possible to obtain a sufficient adhesive strength without heating the bimorph piezoelectric element at a high temperature and to form the protrusions having a satisfactory mechanical strength easily in a short period of time. Referring to Figure 2, a method for producing a piezoelectric vibrator according to the present invention will be described below as being applied to the bimorph piezoelectric vibrator 100 shown in Figure 1.

An electrode 304a and 304B are formed on each principal surface of the two piezoelectric ceramic plates 302. By applying a predetermined voltage across the electrode 304a and 304B, the two piezoelectric ceramic plates 302 are polarized (S1 in Figure 2). Then, the two piezoelectric ceramic plates 302 are attached to each other so that the respective electrodes 304a face outward (as shown in S2 of Figure 2). This attaching step may be performed by using an adhesive, such as a epoxy resin, having high adhesive strength and high elastic modulus. The layer of the adhesive is thin enough not to obstruct the vibration of the piezoelectric element. The attached two electrodes 304b are electrically connected to each other. In figures showing structures of the piezoelectric element after the attaching step, the attached electrodes and the adhesive layer are not shown. The two polarization directions of the two piezoelectric ceramic plates 302 are not limited to the directions P in Figure 11B. These directions may be opposed to each other. That is, the two piezoelectric ceramic plates 302 may be attached to each other so that the respective electrodes 304a face inward.

Next, a metallic mask (not shown) made of inver or the like is placed on one of the electrodes 304a formed on a piezoelectric ceramic plate 302. The metallic mask has an opening in a portion corresponding to the protrusions 303. The height of the protrusions 303 may be adjusted by controlling the time period for thermal spraying. In this example, the thickness of the metallic mask is set to be 0.2 mm. Subsequently, spray particles are sprayed through the opening of the metallic mask onto the electrode 304a by using a plasma spraying apparatus. As a result, the protrusions 303 are formed on the electrode 304a by the spray particles passing through the opening of the metallic mask (as shown in S3 of Figure 2). In the same way, the sprayed protrusions 303 are formed on the other electrode 304a. In place of the metallic mask, a photoresist mask may be placed by a photolithography technique. As a material of photoresist mask, a liquid type resist or a dry-film resist may be used.

Finally, the piezoelectric ceramic plate on which the protrusions 303 are formed are cut so as be divided into a plurality of parts of a predetermined size (as shown in S4 of Figure 2), thereby obtaining piezoelectric vibrators 100 (as shown in S5 of Figure 2). The piezoelectric ceramic plate may be cut by using a dicing apparatus or a wire saw.

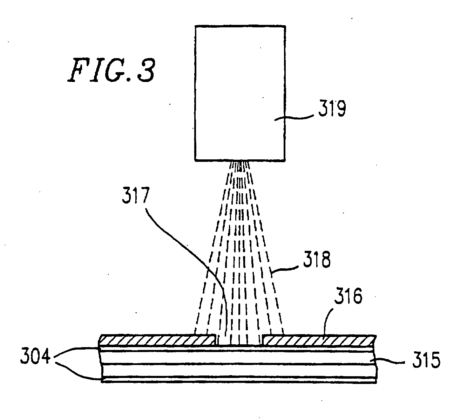

Hereinafter, referring to Figure 3, the thermal spraying process of this example will be described. First, argon gas and helium gas to be used as carrier gases and metal particles are supplied to a plasma spraying apparatus. In this example, the flow rate of argon gas and helium gas is set to be 15 SLM and 3 SLM, respectively (SLM = standard liters per minute). As metal particles, molybdenum particles with an average particle size of 25 µm are used. An arc discharge (arc current: 400 A; voltage: 30 V) is generated inside the plasma spraying apparatus, thereby fusing the metal particles so as to eject the metal spray particles 318 from a plasma torch 319. The spray particles 318 ejected from the plasma torch 319 are sprayed through the opening 317 of the metallic mask 316 onto the piezoelectric ceramic plate 315. As a result, the protrusions are formed at the portions on the piezoelectric ceramic plate 315 which correspond to the opening 17 of the metallic mask 316. All through this process, the piezoelectric ceramic plate 315 stands at an ambient temperature.

According to this thermal spraying process, the minute particles of the metal material and the ceramic material are fused at a high temperature by passing the particles through the plasma at a high temperature, and then the minute particles fused at a high temperature are sprayed onto a substrate with a gas current, thereby forming a coating composed of the minute particles on the substrate.

The formation of the protrusions 303 by the use of the thermal spraying process has the following advantages.
(1) Even a thick film may be formed easily in a short period of time.
(2) The coating to be obtained by the thermal spraying process (hereinafter, simply referred to as a sprayed film) is formed by continuously depositing the minute particles at a high temperature, so that a coating having strong adhesion among the respective particles is obtained.
(3) Although the respective minute particles are fused at a high temperature, the heat capacity of each minute particle is very small, and the minute particles are sprayed onto the substrate with a gas current, so that the increase of the substrate temperature is considerably smaller as compared with the brazing process, the soldering process, and the like.

The point of the method of this example lies in that the protrusions are formed by the thermal spraying process.

According to the thermal spraying process for forming the protrusions, it is possible to easily form protrusions having a sufficient adhesive strength and a satisfactory mechanical strength on a bimorph piezoelectric element in a short period of time without heating the bimorph piezoelectric element at a high temperature. In addition, a thick film with a thickness of 100 µm or more may be formed easily.

In fact, according to the thermal spraying process, the substrate temperature increases to a temperature sufficiently lower than the temperature (about 130°C as shown in Figure 14) where the characteristics of the bimorph piezoelectric element begins to deteriorate. As a result, the increase in the temperature of the bimorph piezoelectric element during the formation of the protrusions is sufficiently lower as compared with a conventional brazing process, or the like, so that the characteristics of the bimorph piezoelectric element are hardly affected by the increase in the temperature of the element itself.

Moreover, since a thick film with a thickness of 100 µm or more may be formed, even when the bimorph piezoelectric element is distorted upon the application of a strong acceleration to the bimorph piezoelectric element, the bimorph piezoelectric element is not likely to come into contact with a holding member or a package, so that the acceleration over a wide range may be detected constantly. Accordingly, the natural features of a bimorph piezoelectric element may be more fully realized.

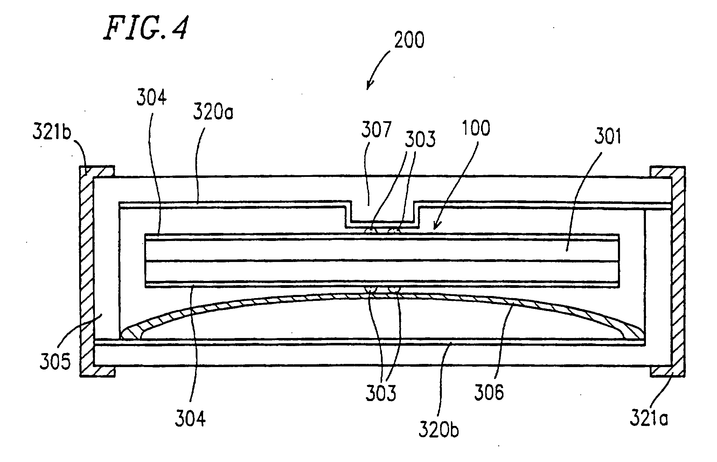

Figure 4 shows a cross-sectional view of an acceleration sensor 200 using the bimorph piezoelectric element 301 shown in Figure 1. Figure 4 is a cross-sectional view of the acceleration sensor 200 in the longitudinal direction. In this example, the size of the element is set as follows: the length: 6 mm; the height: 1.8 mm; and the width: 2.8 mm. The bimorph piezoelectric element 301 is held inside a package (holding body) 305 by sandwiching the bimorph piezoelectric element 301 between an elastic holding member 306 and the convex portion 307 formed on an upper internal surface of the package 305 at the protrusions 303 formed on the bimorph piezoelectric element 301. The elastic holding member 306 is provided for holding the bimorph piezoelectric element 301 by giving a constant pressure thereto and not for obstructing the vibration of the bimorph piezoelectric element 301. The bimorph piezoelectric element 301 is supported at its central portion. The pressure to be given to the bimorph piezoelectric element 301 is determined in consideration of the impact to be externally applied, the strength of the bimorph piezoelectric element 301, the sensitivity of the element 301 to the acceleration, and the like.

When an acceleration having upward components and downward components are given to the acceleration sensor 200 shown in Figure 4, loads are generated in the central portion of the bimorph piezoelectric element 301 held by the holding member 306, so that a distortion is generated in the bimorph piezoelectric element 301. The piezoelectric effect of the bimorph piezoelectric element 301 causes the generation of the charges inside the distorted bimorph piezoelectric element 301. The charges thus generated may be output through the electrodes 304. The amount of the charges to be generated is in proportion to the degree of the distortion, i.e. the degree of the acceleration externally applied, so that the degree of the acceleration may be detected as the amount of electrical charges.

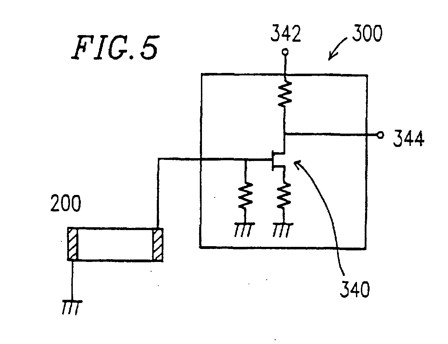

The charges output through the external electrodes 321a and 321b are amplified by the circuit 300 shown in Figure 5, so that the output signals from the circuit 300 may be used as the signals showing the acceleration. The circuit 300 of this example is a current-voltage converting amplifier using a field-effect transistor (FET) 340. The gate of the FET 340 is connected to the external electrode of the acceleration sensor 200. The source of the FET 340 is connected to a power supply 342 through a resister and also to a output terminal 344. According to the present invention, an optimal circuit for the usage of an acceleration sensor, other than this type of circuit, may also be used.

In the structure shown in Figure 4, the central portions of the bimorph piezoelectric element 301 may be held stably and strongly within a narrow holding width. As a result, the resonance frequency of this bimorph piezoelectric element 301 becomes higher than that of a cantilever type bimorph piezoelectric element of the same length in which only one end thereof is held. Accordingly, even acceleration with a higher frequency component may be measured. The distortion is likely to be generated from the portion very near the hold point, therefore, high sensitivity to the acceleration may be obtained.

In addition, since the protrusions 303 may be formed at the predetermined positions with very high precision by the use of a metallic mask, etc., the variation of the hold points may be reduced. The variation of the hold points may be reduced as compared with a holding method using an adhesive or the like, where the variations of the holding width, the hold points, and the holding strength varies depending upon the amount of the adhesives and the temperature,

Moreover, the protrusions 303 are formed by using a conductive material on the electrodes 304 of the bimorph piezoelectric element 301, so that the protrusions 303 may be used for outputting the charges generated in the bimorph piezoelectric element 301 upon the application of an acceleration. A conductive thin film 320a made of silver palladium or the like is formed on the convex portion 307 of the package 305 by a printing process or a plating process, and the thin film 320a is electrically connected to the external electrode 321a provided on an outer surface of the package 305. The elastic holding member 306 is made of conductive metal such as a stainless alloy, and functions as a lead line for outputting the charges from one surface of the bimorph piezoelectric element by coming into contact with the protrusions 303 formed on the electrode 304 of the bimorph piezoelectric element 301 upon the application of a pressure. A electrically conductive thin film 320b electrically connected to an external electrode 321b is formed on an internal surface of the package 305 so as to be in contact with the elastic holding member 306, thereby electrically connecting the electrode 304 on the other surface of the bimorph piezoelectric element 301 to the external electrode 21b. In this way, the charges generated in the bimorph piezoelectric element 301 upon the application of an acceleration may be output easily without using a conductive adhesive or the like, and the variation of the characteristics caused by the dispersion of the application range of a conductive adhesive may be prevented.

As a piezoelectric element for detecting the acceleration, not only a bimorph piezoelectric element but also a multi-layered piezoelectric element obtained by attaching multiple piezoelectric plates to each other, a single-layered piezoelectric element, and a unimorph piezoelectric element obtained by attaching a piezoelectric plate to a shim material may be used. As a bimorph piezoelectric element, an element obtained by sandwiching a shim material may be used. In addition, a piezoelectric element including a piezoelectric film deposited on a substrate and an electrode may be used. The piezoelectric material is not limited to piezoelectric ceramic but lithium niobate or the like may also be used. In place of molybdenum, metal materials such as nickel-chrome alloy, stainless alloy, tungsten, brass, silver, copper alloy, and aluminum alloy; or an electrically conductive ceramic material may be used as a material for forming the protrusions 303. The number of the linear protrusions 303 to be formed on each surface is not limited to two, but may be one, three, or more if it is necessary for stabilizing the hold point on the protrusions or for adapting the protrusions to the area to be held. The same effects may be attained in the case of using different numbers of protrusions for the respective surfaces of a bimorph vibrator to be held. Furthermore, the shape of the protrusions 303 is not necessarily required to be linear.

As is apparent from the foregoing description, a highly reliable small-sized acceleration sensor, which exhibits high sensitivity to any acceleration applied and shows a small variation of the characteristics, may be obtained by using a spraying process in which protrusions, showing a mechanical strength strong enough not to be plastically deformed largely even under a pressure given from above and from below; and a sufficient adhesive strength without heating a bimorph piezoelectric element at a high temperature, are formed in the central portions of the bimorph piezoelectric element, and held stably.

### Example 2

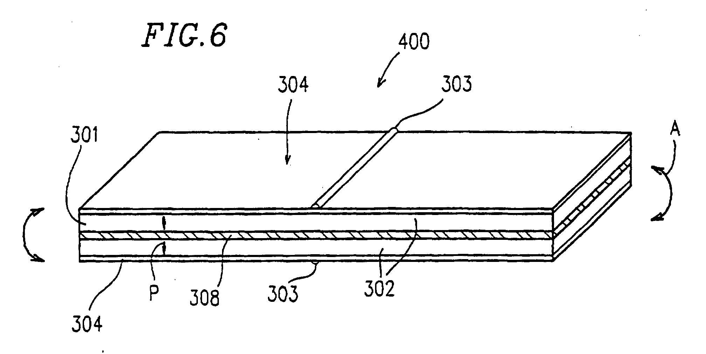

Figure **6** is a perspective view of a piezoelectric vibrator 400 for constituting an acceleration sensor according to a second example of the present invention. A bimorph piezoelectric element 301 formed by sandwiching and bonding a shim between a pair of piezoelectric ceramic plates 302 is used as a piezoelectric vibrator. As a shim 308, a phosphorus-bronze plate, a stainless plate, or the like may be used. The shim 308 increases the mechanical strength of a piezoelectric vibrator, and facilitates the mounting of the vibrator into a package. Electrodes 304 are formed on both opposed principal surfaces of the piezoelectric vibrator. In the central portion of each principal surface of the bimorph piezoelectric element 301, a linear metallic protrusion 303 made of a relatively harder metal material such as a nickel-chrome alloy, nickel-chrome-aluminum alloy or molybdenum or a conductive ceramic material is formed by a thermal spraying process or the like so as to have a fine ruggedness of several µm to several hundreds of µm. In this case, the width and the thickness of the protrusion 303 are determined so that the protrusions 303 hold the bimorph piezoelectric element 301 stably in view of the vibration-resistance and the impact-resistance thereof, and the effect to be given to the characteristics of the piezoelectric vibrator. The material for the protrusions 303 is required to be mechanically stable under the holding force, and to exhibit constant electrical properties for functioning as the lead lines. Therefore, the material for the protrusions 303 is selected in consideration of rust-resistance, the electric conductivity, the elastic modulus (or the hardness) thereof, and the like.

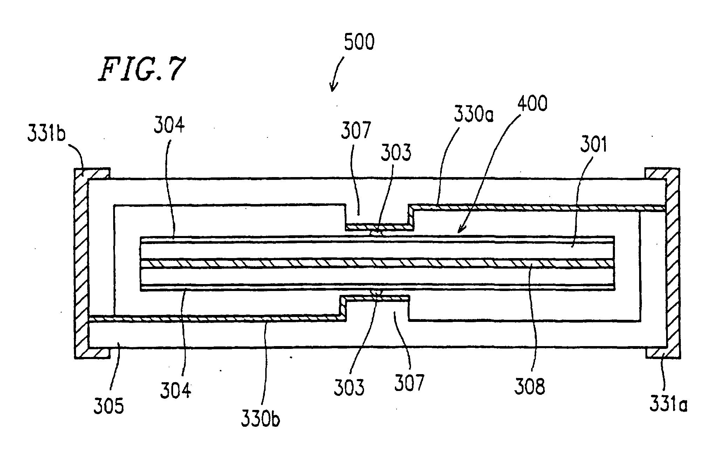

Figure 7 is a cross-sectional view of a holding structure for the piezoelectric vibrator 400 shown in Figure 6 for constituting an acceleration sensor 500 of the present invention along the longitudinal direction of the piezoelectric vibrator 400. The convex portions 307 formed on the two opposed internal surfaces of the package 305 are made of a PPS resin or the like. The gap between the two convex portions 307 is determined so that the bimorph piezoelectric element 301 is held stably in consideration of the mechanical properties such as hardness, Young's modulus and the like of the package 305 and the protrusions 303. The piezoelectric vibrator 400 is held by being press-fitted between the two convex portions 307 formed inside the package 305. In the case where the convex portions 307 of the package 305 are made of a material with a lower hardness than that for the protrusions, the fine ruggedness in the contact areas of the top ends of the protrusions engage into the convex portions 307 of the package 305, so that the bimorph piezoelectric vibrator 400 is held stably. Even if the contact areas between the piezoelectric vibrator 400 and the convex portions 307 of the package 305 functioning as holding members is reduced by reducing the area of the top ends of the protrusions 303, such a mechanical engagement makes it possible to hold the piezoelectric vibrator 400 stably so as to exhibit excellent vibration-resistance and impact-resistance.

An electrode pattern electrically connected to the external electrode is formed on each upper surface of the two convex portions 307 of the package 305 by a plating process or the like. If the conductive protrusions come into contact with the electrode patterns 330, then the electrodes 304 formed over both principal surfaces of the bimorph piezoelectric element 301 become electrically conductive with the external electrodes 331a and 331b, and therefore the output signals to be generated upon the application of an acceleration may be output easily.

In the first example described above, electrically conductive protrusions to be formed on the piezoelectric vibrator are made of a relatively harder metal material such as a nickel-chrome alloy, a nickel-chrome-aluminum alloy and molybdenum. In the same way, a metal material such as a stainless alloy, tungsten, brass, copper alloy and an aluminum alloy may be used. In addition, the same effects may be attained by using a ceramic material so long as the material has an electrical conductivity. A ceramic material or the like is used for the convex portions of the package, instead of a PPS resin used in this example. Alternatively, only the convex portions may be made of a resin, while the remaining portions of the package may be made of a ceramic material or the like.

As described above, according to the present invention, the piezoelectric vibrator is held by being press-fitted between the conductive protrusions formed on the piezoelectric vibrator and the convex portions inside the package; and the fine ruggedness on the top portions of the conductive protrusions formed on the piezoelectric vibrator engage into the contact areas between the protrusions and the holding members for the piezoelectric vibrator because of the difference in the hardness between the holding members and the protrusions, so that a mechanical engagement is established between the holding members and the protrusions and the piezoelectric vibrator may be held stably. In addition, even if the contact area between the piezoelectric vibrator and the - holding members is enlarged, an effective contact area may be kept small because of the fine ruggedness on the top ends of the protrusions. Accordingly, the piezoelectric vibrator is stably held so as to exhibit excellent characteristics; and a highly reliable small-sized acceleration sensor having high sensitivity to the acceleration and a small variation of the characteristics may be provided.

### Example 3

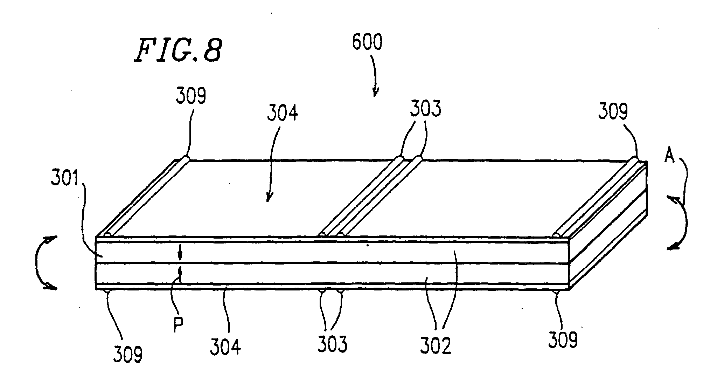

Figure **8** is a perspective view showing a piezoelectric vibrator 600 for constituting an acceleration sensor according to a third example of the present invention. As shown in Figure 8, a bimorph piezoelectric element 301 is formed by attaching two piezoelectric ceramic plates 302 to each other; and an electrode 304 is formed on each principal surface of the piezoelectric ceramic plates 302. In the central portions of the two opposed principal surfaces of the bimorph piezoelectric element 301, the protrusions made of molybdenum are formed linearly on the respective electrodes 304 by a thermal spraying process. Moreover, additional-mass portions 309, which function as an additional-mass made of a metal material are linearly formed in both end portions of the two principal surfaces of the bimorph piezoelectric element 301. In this example, the additional-mass portions 309 and the protrusions 303 for holding the central portions are formed at the same time using molybdenum for both portions by a thermal spraying process.

In this case, the width and the thickness of the protrusions 303, and the gap between the two protrusions 303 formed on each surface are determined so that the protrusions 303 hold the bimorph piezoelectric element 301 stably in view of the vibration-resistance and the impact-resistance thereof, and the effect to be given to the characteristics of the piezoelectric vibrator 301. The material for the protrusions 303 is required to be mechanically stable even under the holding force, and to exhibit constant electrical properties for functioning as the lead lines. Therefore, the material for the protrusions 303 is selected in consideration of the conductivity, the elastic modulus (or the hardness), the rust-resistance thereof, and the like. A process for forming the protrusions 303 is selected so that the protrusions having a sufficient mechanical strength and showing a sufficient adhesive strength without heating the piezoelectric vibrator to a high temperature are easily obtained at a higher rate than conventional. Accordingly, the deterioration of the characteristics of the piezoelectric vibrator is almost negligible, and therefore the natural properties of the piezoelectric vibrator may be utilized.

The additional-mass portions 309 formed on both end portions of the two principal surfaces of the bimorph piezoelectric element 301 improves the sensitivity of the element 301 to any acceleration. The additional mass 309 is determined in view of the necessary sensitivity, and a desirable mass may be obtained by changing the film thickness. The additional mass portions 309 may be formed at the same time as the formation of the central protrusions 303 by using a mask. Therefore, the additional mass portions 309 may be formed without increasing the number of production steps. In forming the additional mass portions 309, if a material of a high density for satisfying the necessary conditions for the material of the protrusions is used for the additional mass portions 309, even greater effects may be attained.

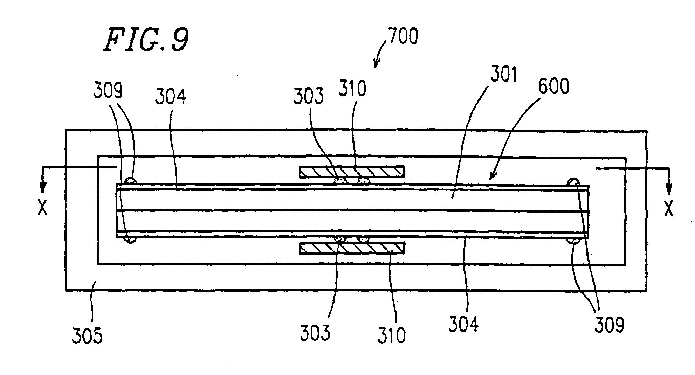

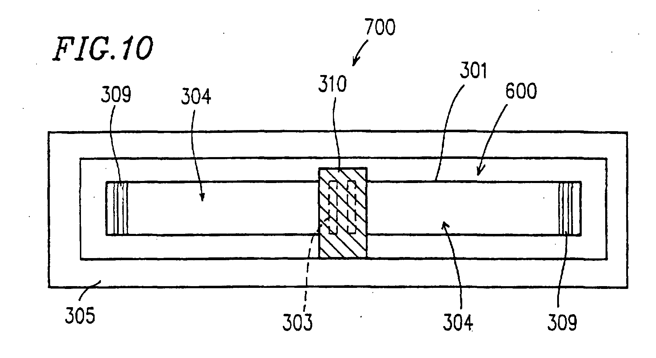

Figure 9 is a cross-sectional view of a holding structure of the bimorph piezoelectric vibrator 600 shown in Figure 8 for constituting an acceleration sensor 700 of the present invention along the longitudinal direction of the piezoelectric vibrator 600. Figure 10 is a cross-sectional view of the acceleration sensor 700 taking along the X-X direction in Figure 9. The bimorph piezoelectric element 301 is held by sandwiching the element 301 between a pair of elastic holding members 310 at the protrusions 303 formed in the central portions of the bimorph piezoelectric element 301, and then the holding members 310 are held inside the package 305. The elastic holding members 310 may hold the piezoelectric vibrator 600 by giving a constant pressure thereto, and may hold the central protrusions of the piezoelectric vibrator 600 strongly and stably within a narrow holding width without obstructing the vibration of the piezoelectric vibrator 600, so that the distortion caused by the vibration is likely to be generated very near the hold points and high sensitivity to any acceleration may be obtained.

In addition, since the protrusions 303 may be formed at the predetermined positions with very high precision by the use of a metallic mask, etc., the variation of the hold points may be reduced. The variation may be reduced as compared with a holding method using an adhesive or the like, where the variations of the holding width, the hold points, and the holding strength varies depending on the amount of the adhesive and the temperature.

The protrusions 303 are formed on the electrodes 304 of the piezoelectric vibrator 600 by using a conductive material, and play the part of outputting the charges generated in the piezoelectric vibrator 600 upon the application of an acceleration. The elastic holding members 310 have an electrical conductivity so as to function also as the lead lines, and are disposed so that the electrodes 304 provided over both principal surfaces of the piezoelectric vibrator 600 are not short-circuited. Conductive patterns maintaining a conductivity with the external electrodes are formed at the positions inside the package where the elastic holding members 310 are held. Therefore, by holding the elastic holding members 310 at such positions, the electrodes formed on both principal surfaces of the piezoelectric vibrator 600 are electrically connected to the external electrodes.

In holding the elastic holding members 310 inside the package, the members 310 may be press-fitted to the package or may be bonded with a conductive adhesive or the like. Even a small-sized piezoelectric element may be treated easily if the piezoelectric vibrator is sandwiched between the elastic holding members and then held inside the package.

As a piezoelectric element for detecting the acceleration, not only a bimorph piezoelectric element but also a multi-layered piezoelectric element obtained by attaching multiple piezoelectric plates to each other, a single-layered piezoelectric element, and a unimorph piezoelectric element obtained by attaching a piezoelectric plate to a shim material may be used. As a bimorph piezoelectric element, an element obtained by sandwiching a shim material may be used. In addition, a piezoelectric element including a piezoelectric film deposited on a substrate and an electrode may be used. The shape of the piezoelectric vibrator is not limited to a rectangular shape, but may be a disc shape. A piezoelectric material is not limited to piezoelectric ceramic but lithium niobate or the like may also be used. In place of molybdenum, metal materials such as nickel-chrome alloy, stainless alloy, tungsten, brass, silver, copper alloy and aluminum alloy; or an electrically conductive ceramic material may be used as a material for forming the protrusions 303. The number of the linear holding protrusions 303 is not limited to one for each principal surface, and the number of the linear additional mass portions 309 is not limited to one for each end portion, but two or more protrusions and additional-mass portions may be formed, or they may be formed on only one principal surface of the piezoelectric vibrator. The shape of the holding protrusions 303 and the additional mass portions 309 is not limited to a linear shape, but a plurality of dot-shaped protrusions may be formed instead. The thickness of the additional mass portions 309 is not necessarily required to be the same as the thickness of the holding protrusions 303. In order to increase the additional mass, after the holding protrusions 303 are formed so as to have a predetermined thickness, metal particles or the like may be further sprayed only to the additional mass portions by covering the holding protrusions 303 with a mask, etc. The same kind of material is not necessarily used for the additional mass portions and for the holding protrusions, but different kinds of materials may be used, respectively.

As is apparent from the foregoing description, a highly reliable small-sized acceleration sensor, which exhibits high sensitivity to the acceleration to be applied and shows a small variation of characteristics, may be obtained by using a thermal spraying process in which protrusions, showing a mechanical strength strong enough not to be plastically deformed largely even under a pressure given from above and below; and a sufficient adhesive strength without heating a piezoelectric vibrator at a high temperature, are formed in the central portions of the piezoelectric vibrator and held stably by the holding members, and then the holding members are held inside the package.

A piezoelectric vibrator of an acceleration sensor of this invention includes conductive protrusions made of a metal material or a ceramic material formed by a thermal spraying process, and the piezoelectric vibrator. Since the conductive protrusions formed by the thermal spraying process are excellent in mechanical strength and adhesive strength, the piezoelectric vibrator may be held stably. As a result, an acceleration sensor having excellent impact-resistance may be provided. By holding the piezoelectric vibrator at the central portions thereof, the end portions of the vibrator are allowed to vibrate freely in the same way as a piezoelectric vibrator under a cantilever type structura. Therefore, the vibrator exhibits high sensitivity and may detect an acceleration (vibration) even in a high frequency region. Since the area necessary for holding the piezoelectric vibrator is small, an acceleration sensor of a small size may be provided. Moreover, since the electrodes formed on the respective principal surfaces of the piezoelectric vibrator are connected to outside of the package through the conductive protrusions formed on the respective electrodes, the structure of the acceleration sensor may be simplified and small.

According to the production method of an acceleration sensor of the invention, the conductive protrusions are formed by the thermal spraying process, so that the piezoelectric element is never heated at a high temperature during a processing. Therefore, a method in which thermal deterioration of the piezoelectric characteristics is prevented may be provided. Furthermore, the conductive protrusions may be processed with high precision by the thermal spraying process, thereby providing a method excellent in the reproducibility of the piezoelectric characteristics, the stable mass-productivity.

## Claims

1. An acceleration sensor (200) comprising a piezoelectric vibrator (100) including a piezoelectric element (301) having a first principal surface and a second principal surface opposed to each other, a first and a second electrode (304) formed on the first and the second principal surface, respectively, conductive protrusions (303) made of a metal material or a ceramic material and formed on said first and the second principal surface, and protrusions (309) made of a metal material or a ceramic material and formed in longitudinal end portions of the piezoelectric vibrator on at least one of the first and second electrodes; and a holding body (305) for holding the piezoelectric vibrator (100) via the conductive protrusions (303).

2. An acceleration sensor according to claim 1, wherein the conductive protrusions are formed in longitudinal central portions of the piezoelectric vibrator.

3. An acceleration sensor according to claim 1, wherein the holding body includes a holding member having an elastic property, and the piezoelectric vibrator is held by the holding member via at least one of the conductive protrusions formed on the first and second electrode of the piezoelectric vibrator.

4. An acceleration sensor according to claim 1, wherein the piezoelectric vibrator is press-fitted into the holding body and the piezoelectric vibrator is held via the conductive protrusions by the holding body.

5. An acceleration sensor according to claim 1, wherein the holding body includes a holding member made of a material having a lower hardness than that of the conductive protrusions and at least one of the protrusions is press-fitted into the holding member.

6. An acceleration sensor according to claim 1, wherein the piezoelectric element is selected from a group including: a bimorph piezoelectric element; a multilayered piezoelectric element obtained by attaching multiple piezoelectric plates; a single layered piezoelectric element; a unimorph piezoelectric element obtained by attaching a piezoelectric plate to a shim; a bimorph piezoelectric element interposing a shim therebetween; and a piezoelectric element including a piezoelectric film deposited on a substrate and an electrode.

7. An acceleration sensor according to claim 1, wherein the conductive protrusions are arranged in a symmetric manner on the first and the second electrodes.

8. An acceleration sensor according to claim 1, wherein the conductive protrusions are linear protrusions extending in a width direction of the piezoelectric vibrator.

9. An acceleration sensor according to claim 1, wherein a length in a longitudinal direction of the piezoelectric element is longer than 3.5 times of that in width direction.

10. An acceleration sensor according to claim 1, wherein a height of the conductive protrusions is in a range of 50 µm to 150 µm.

11. A method of producing an acceleration sensor (200) comprising a piezoelectric vibrator (100) including a piezoelectric element (301) having a first principal surface and a second principal surface opposed to each other, a first and a second electrode (304) formed on the first and the second principal surface, respectively, and a holding body (305) for holding the piezoelectric vibrator (100) via the conductive protrusions (303), comprising the step of:
forming electrodes (304) on said first and second principal surfaces,
forming said conductive protrusions (303) by thermally spraying a metal material or a ceramic material on the first and second electrodes (304),
forming protrusions (309) by thermally spraying a metal material or a ceramic material in longitudinal end portions of the piezoelectric vibrator (100) on at least one of the first and second electrodes, and
arranging said piezoelectric vibrator in said holding body (305) so as to be held via said conductive protrusions (303).

12. A method for producing an acceleration sensor according to claim 11, further comprising a step of forming a holding body for holding the piezoelectric element via the conductive protrusions.

13. A method for producing an acceleration sensor according to claim 11, wherein the conductive protrusion forming step includes a step of forming the protrusions on the piezoelectric element by thermally spraying a metal material or a ceramic material via a mask having a opening in a portion corresponding to a longitudinal central portion of the piezoelectric vibrator.

14. A method for producing an acceleration sensor according to claim 11, wherein the opening is a linear opening extending in a width direction of the piezoelectric vibrator.

15. A method for producing an acceleration sensor according to claim 11, wherein the protrusion is formed on the first and the second electrodes.

16. A method for producing an acceleration sensor according to claim 11, wherein a height of the conductive protrusions is in a range of 50 µm to 150 µm.

17. A method for producing an acceleration sensor according to claim 12, wherein the holding body includes a holding member having an elastic property, and the piezoelectric vibrator is held by the holding member via at least one of the conductive protrusions formed on the first and second electrode of the piezoelectric vibrator.

18. A method for producing an acceleration sensor according to claim 12, wherein the holding body includes a holding member made of a material having a lower hardness than that of the conductive protrusions and at least one of the protrusions is press-fitted into the holding member.

## Patentansprüche

1. Beschleunigungsmessaufnehmer (200) mit einem piezoelektrischen Vibrator (100), enthaltend ein piezoelektrisches Element (301) mit einer ersten Haupt-Oberfläche und eine zweiten Haupt-Oberfläche, die einander gegenüberliegen, eine erste und eine zweite Elektrode (304), die auf der ersten bzw. der zweiten Haupt-Oberfläche ausgebildet sind, leitende Vorsprünge (301), die aus einem Metall-Material oder einem keramischen Material hergestellt und auf der ersten und der zweiten Haupt-Oberfläche ausgebildet sind, und Vorsprünge (309), die aus einem Metall-Material oder einem keramischen Material hergestellt und in longitudinalen End-Bereichen des piezoelektrischen Vibrators auf wenigstens einer der ersten und zweiten Elektroden ausgebildet sind; und mit einem Halte-Körper (305) zum Halten des piezoelektrischen Vibrators (100) über die leitenden Vorsprünge (303).

2. Beschleunigungsmessaufnehmer nach Anspruch 1, wobei die leitenden Vorsprünge in longitudinalen, zentralen Bereichen des piezoelektrischen Vibrators ausgebildet sind.

3. Beschleunigungsmessaufnehmer nach Anspruch 1, wobei der Halte-Körper ein Halteelement mit einer elastischen Eigenschaft enthält, und wobei der piezoelektrische Vibrator durch das Halteelement über wenigstens einen der leitenden Vorsprünge gehalten ist, der auf der ersten und zweiten Elektrode des piezoelektrischen Vibrators ausgebildet ist.

4. Beschleunigungsmessaufnehmer nach Anspruch 1, wobei der piezoelektrische Vibrator durch Presspassung in dem Halte-Körper befestigt ist, und wobei der piezoelektrische Vibrator über die leitenden Vorsprünge durch den Halte-Körper gehalten wird.

5. Beschleunigungsmessaufnehmer nach Anspruch 1, wobei der Halte-Körper ein Halteelement enthält, das aus einem Material mit einer niedrigeren Härte als die der leitenden Vorsprünge hergestellt ist, und wobei wenigstens einer der Vorsprünge durch Presspassung in dem Halteelement befestigt ist.

6. Beschleunigungsmessaufnehmer nach Anspruch 1, wobei das piezoelektrische Element aus einer Gruppe ausgewählt ist, die enthält: Ein bimorphes piezoelektrisches Element; ein aus mehreren Schichten bestehendes, piezoelektrisches Element, das durch Anbringung mehrfacher piezoelektrischer Platten erhalten wird; ein aus einer einzigen Schicht bestehendes piezoelektrisches Element; ein unimorphes piezoelektrisches Element, das durch Anbringung einer piezoelektrischen Platte an einem Abstandsstück bzw. einer Ausgleichscheibe erhalten wird; ein bimorphes piezoelektrisches Element, zwischen dem ein Abstandsstück bzw. eine Ausgleichsscheibe angeordnet ist; und ein piezoelektrisches Element, das einen auf einem Substrat abgelagerten piezoelektrischen Film und eine Elektrode enthält.

7. Beschleunigungsmessaufnehmer nach Anspruch 1, wobei die leitenden Vorsprünge in einem symmetrischen Muster auf der ersten und der zweiten Elektrode angeordnet sind.

8. Beschleunigungsmessaufnehmer nach Anspruch 1, wobei die leitenden Vorsprünge lineare bzw. linienförmige Vorsprünge sind, die sich in einer Breiten-Richtung des piezoelektrischen Vibrators erstrecken.

9. Beschleunigungsmessaufnehmer nach Anspruch 1, wobei die Länge des piezoelektrischen Elementes in einer longitudinalen Richtung länger als das 3,5-fache der Länge in Breiten-Richtung ist.

10. Beschleunigungsmessaufnehmer nach Anspruch 1, wobei die Höhe der leitenden Vorsprünge im Bereich von 50 *µ*m bis 150 *µ*m liegt.

11. Verfahren zur Herstellung eines Beschleunigungsmessaufnehmers (200) mit einem piezoelektrischen Schwingungserzeuger bzw. Vibrator (100), enthaltend ein piezoelektrisches Element (301) mit einer ersten Haupt-Oberfläche und einer zweiten Haupt-Oberfläche, die einander gegenüberliegen, eine erste und eine zweite Elektrode (304), die auf der ersten bzw. der zweiten Haupt-Oberfläche ausgebildet sind, und mit einem Halte-Körper (305) zum Halten des piezoelektrischen Vibrators (100) über die leitenden Vorsprünge (303), mit den folgenden Schritten:
Ausbildung der Elektroden (304) auf der ersten und der zweiten Haupt-Oberfläche,
Ausbilden des leitenden Vorsprungs bzw. der leitenden Vorsprünge (303) durch thermisches Spritzen eines Metall-Materials oder eines keramischen Materials auf die erste und die zweite Elektrode (304),
Ausbildung des Vorsprungs bzw. von Vorsprüngen (309) durch thermisches Spritzen eines Metall-Materials oder eines keramischen Materials in longitudinalen End-Bereichen des piezoelektrischen Vibrators (100) auf wenigstens eine der ersten und zweiten Elektroden, und
Anordnen des piezoelektrischen Vibrators in dem Halte-Körper (305), so dass er über die leitenden Vorsprünge (303) fixiert ist.

12. Verfahren zur Herstellung eines Beschleunigungsmessaufnehmers nach Anspruch 11, weiterhin aufweisend den Schritt der Ausbildung eines Halte-Körpers zum Halten des piezoelektrischen Elementes über den leitenden Vorsprung bzw. die leitenden Vorsprünge.

13. Verfahren zur Herstellung eines Beschleunigungsmessaufnehmers nach Anspruch 11, wobei der Schritt der Ausbildung des leitenden Vorsprungs einen Schritt zur Ausbildung des Vorsprungs bzw. der Vorsprünge auf dem piezoelektrischen Element durch thermisches Spritzen eines Metall-Materials oder eines keramischen Materials über eine Maske mit einer Öffnung in einem Bereich enthält, der einem longitudinalen zentralen Bereich des piezoelektrischen Vibrators entspricht.

14. Verfahren zur Herstellung eines Beschleunigungsmessaufnehmers nach Anspruch 11, wobei die Öffnung eine lineare bzw. linienförmige Öffnung ist, die sich in einer Breiten-Richtung des piezoelektrischen Vibrators erstreckt.

15. Verfahren zur Herstellung eines Beschleunigungsmessaufnehmers nach Anspruch 11, wobei der Vorsprung auf der ersten und der zweiten Elektrode ausgebildet ist.

16. Verfahren zur Herstellung eines Beschleunigungsmessaufnehmers nach Anspruch 11, wobei die Höhe der leitenden Vorsprünge im Bereich von 50 µm bis 150 µm liegt.

17. Verfahren zur Herstellung eines Beschleunigungsmessaufnehmers nach Anspruch 12, wobei der Halte-Körper ein Halte-Element mit einer elastischen Eigenschaft enthält, und wobei der piezoelektrische Vibrator durch das Halte-Element über wenigstens einen der leitenden Vorsprünge fixiert wird, der auf der ersten und der zweiten Elektrode des piezoelektrischen Vibrators ausgebildet ist.

18. Verfahren zur Herstellung eines Beschleunigungsmessaufnehmers nach Anspruch 12, wobei der Halte-Körper ein Halte-Element enthält, das aus einem Material mit einer geringeren Härte als der der leitenden Vorsprünge hergestellt ist, wobei wenigstens einer der Vorsprünge durch Presspassung in dem Halte-Element befestigt ist.

## Revendications

1. Capteur d'accélération (200) comprenant un vibrateur piézoélectrique (100) incluant un élément piézoélectrique (301) comprenant une première surface principale et une seconde surface principale opposées l'une à l'autre, une première et une seconde électrodes (304) formées sur la première et la seconde surfaces principales, respectivement, des saillies conductrices (303) faites d'un matériau métallique ou d'un matériau céramique et formées sur lesdites première et seconde surfaces principales, et des saillies (309) faites d'un matériau métallique ou bien d'un matériau céramique et formées dans des parties d'extrémité longitudinales du vibrateur piézoélectrique sur au moins l'une des première et seconde électrodes, et un corps de maintien (305) destiné à maintenir le vibrateur piézoélectrique (100) par l'intermédiaire des saillies conductrices (303).

2. Capteur d'accélération selon la revendication 1, dans lequel les saillies conductrices sont formées dans des parties centrales longitudinales du vibrateur piézoélectrique.

3. Capteur d'accélération selon la revendication 1, dans lequel le corps de maintien comprend un élément de maintien présentant une propriété élastique, et le vibrateur piézoélectrique est maintenu par l'élément de maintien par l'intermédiaire d'au moins l'une des saillies conductrices formées sur les première et seconde électrodes du vibrateur piézoélectrique.

4. Capteur d'accélération selon la revendication 1, dans lequel le vibrateur piézoélectrique est étroitement ajusté dans le corps de maintien et le vibrateur piézoélectrique est maintenu par l'intermédiaire des saillies conductrices par le corps de maintien.

5. Capteur d'accélération selon la revendication 1, dans lequel le corps de maintien comprend un élément de maintien fait d'un matériau présentant une dureté inférieure à celle des saillies conductrices et au moins l'une des saillies est ajustée de façon serrée dans l'élément de maintien.

6. Capteur d'accélération selon la revendication 1, dans lequel l'élément piézoélectrique est sélectionné à partir d'un groupe comprenant : un élément piézoélectrique bimorphe, un élément piézoélectrique à couches multiples obtenu en fixant des plaques piézoélectriques multiples, un élément piézoélectrique à une seule couche, un élément piézoélectrique unimorphe obtenu en fixant une plaque piézoélectrique à un élément d'épaisseur, un élément piézoélectrique bimorphe en y interposant un élément d'épaisseur entre, et un élément piézoélectrique comprenant un film piézoélectrique déposé sur un substrat et une électrode.

7. Capteur d'accélération selon la revendication 1, dans lequel les saillies conductrices sont agencées d'une manière symétrique sur les première et seconde électrodes.

8. Capteur d'accélération selon la revendication 1, dans lequel les saillies conductrices sont des saillies linéaires s'étendant en direction de la largeur du vibrateur piézoélectrique.

9. Capteur d'accélération selon la revendication 1, dans lequel une longueur dans une direction longitudinale de l'élément piézoélectrique est plus longue de 3,5 fois celle dans la direction de la largeur.

10. Capteur d'accélération selon la revendication 1, dans lequel une hauteur des saillies conductrices se trouve dans une plage de 50 µm à 150 µm.

11. Procédé de fabrication d'un capteur d'accélération (200) comprenant un vibrateur piézoélectrique (100) incluant un élément piézoélectrique (301) comportant une première surface principale et une seconde surface principale opposées l'une à l'autre, une première et une seconde électrodes (304) formées sur la première et la seconde surfaces principales, respectivement, et un corps de maintien (305) destiné à maintenir le vibrateur piézoélectrique (100) par l'intermédiaire des saillies conductrices (303), comprenant les étapes consistant à :
former les électrodes (304) sur lesdites première et seconde surfaces principales,
former lesdites saillies conductrices (303) en pulvérisant thermiquement un matériau métallique ou bien un matériau céramique sur les première et seconde électrodes (304),
former des saillies (309) en pulvérisant de façon thermique un matériau métallique ou un matériau céramique dans des parties d'extrémité longitudinales du vibrateur piézoélectrique (100) sur au moins l'une des première et seconde électrodes, et
agencer ledit vibrateur piézoélectrique dans ledit corps de maintien (305) de façon à être maintenu par l'intermédiaire desdites saillies conductrices (303).

12. Procédé de fabrication d'un capteur d'accélération selon la revendication 11, comprenant en outre une étape consistant à former un corps de maintien destiné à maintenir l'élément piézoélectrique par l'intermédiaire desdites saillies conductrices.

13. Procédé de fabrication d'un capteur d'accélération selon la revendication 11, dans lequel l'étape de formation de la saillie conductrice comprend une étape consistant à former les saillies sur l'élément piézoélectrique en pulvérisant de façon thermique un matériau métallique ou bien un matériau céramique par l'intermédiaire d'un masque comportant une ouverture dans une partie correspondant à une partie centrale longitudinale du vibrateur piézoélectrique.

14. Procédé de fabrication d'un capteur d'accélération selon la revendication 11, dans lequel l'ouverture est une ouverture linéaire s'étendant dans une direction de la largeur du vibrateur piézoélectrique.

15. Procédé de fabrication d'un capteur d'accélération selon la revendication 11, dans lequel la saillie est formée sur les première et seconde électrodes.

16. Procédé de fabrication d'un capteur d'accélération selon la revendication 11, dans lequel une hauteur des saillies conductrices se trouve dans une plage de 50 µm à 150 µm.

17. Procédé de fabrication d'un capteur d'accélération selon la revendication 12, dans lequel le corps de maintien comprend un élément de maintien présentant une propriété élastique, et le vibrateur piézoélectrique est maintenu par l'élément de maintien par l'intermédiaire d'au moins l'une des saillies conductrices formées sur les première et seconde électrodes du vibrateur piézoélectrique.

18. Procédé de fabrication d'un capteur d'accélération selon la revendication 12, dans lequel le corps de maintien comprend un élément de maintien fait d'un matériau présentant une dureté inférieure à celle des saillies conductrices et au moins l'une des saillies est ajustée de façon serrée dans l'élément de maintien.
